# EUROPEAN PATENT APPLICATION

(11) **EP 1 189 290 A1**
(43) Date of publication of application: **20.03.2002**
(21) Application number: 01121927.6
(22) Date of filing: 12.09.2001
(51) Int. Cl.: H01L 33/00, H01S 5/327

(54) **Semiconductor device having ZnO based oxide semiconductor layer and method of manufacturing the same**

(30) Priority: 13.09.2000 JP 2000278041
(71) Applicant: DIRECTOR-GENERAL OF NATIONAL INSTITUTE OF ADVANCED INDUSTRIAL SCIENCE AND TECHNOLOGY, Chiyoda-ku Tokyo (JP); ROHM CO., LTD., Kyoto (JP)
(72) Inventor: Iwata, Kakuya, Tsukuba-shi, Ibaraki (JP); Fons, Paul, Tsukuba-shi, Ibaraki (JP); Matsubara, Koji, Tsukuba-shi, Ibaraki (JP); Yamada, Akimasa, Inashiki-gun, Ibaraki (JP); Niki, Shigeru, Tsukuba-shi, Ibaraki (JP); Nakahara, Ken, c/o Rohm Co., Ltd., Kyoto-shi (JP)
(74) Representative: Leson, Thomas Johannes Alois, Dipl.-Ing.

(57) **Abstract**

In an LED, for example, a light emitting layer forming portion (10) composed of a ZnO based oxide semiconductor is provided on a substrate (11), which includes at least an n-type layer (14) and a p-type layer (16) to form a light emitting layer. The p-type layer (16) contains phosphorus as a dopant. In order to dope such phosphorus, for example, a material having a bond of Zn and P such as Zn₃P₂ is used when growing a ZnO based oxide semiconductor. As a result, it is possible to obtain a semiconductor device including a p-type ZnO based oxide semiconductor layer having a stable and high carrier concentration and a method of manufacturing the semiconductor device.

## Description

### FIELD OF THE INVENTION

The present invention relates to a blue based (a wavelength region from ultraviolet to yellow) semiconductor light emitting device to be used in a light source for a next generation DVD disc or the like, a semiconductor device having a p-type ZnO based oxide semiconductor layer such as a transparent conductive film or a transparent TFT and a method of manufacturing the same. More specifically, the present invention relates to a semiconductor device for growing a p-type ZnO based oxide semiconductor layer grown at a high carrier concentration by using a compound of zinc and phosphorus as a material of a p-type dopant and a method of manufacturing the semiconductor device.

### BACKGROUND OF THE INVENTION

A blue based light emitting diode (hereinafter referred to as an LED) to be used for a full color display or a light source such as a signal light and a blue laser (hereinafter referred to as an LD) for a very fine DVD light source for a next generation which continuously oscillates at a room temperature can be obtained by providing a GaN based compound semiconductor on a sapphire substrate and have recently attracted the attention. While the GaN based compound semiconductor is in major in the light emitting device having a short wavelength, it has also been investigated that II-VI compound semiconductor such as ZnO is used. The ZnO has a band gap of 3.37 eV at a room temperature and it has also been expected that the ZnO based oxide can be applied to a transparent conductive film, a transparent TFT or the like in addition to the DVD light source.

In ZnSe to be II-VI compound, a p-type semiconductor layer has been implemented by activating a nitrogen gas using a plasma and doping the activated nitrogen. However, the same method has been tried for the ZnO and a p-type layer having a high carrier concentration has not been implemented. Although the reason is not definite, for example, it has been published that nitrogen entering an oxygen site of ZnO (the condition of p-type conduction) creates a deep acceptor level of approximately 200 meV, and furthermore, makes crystal structure unstable and generates an oxygen hole so that doping of ZnO with nitrogen becomes hard in "Solution using a codoping method to Unipolarity for the fabrication of p-type ZnO" (Japanese Journal of Applied Physics, Vol. 38, pp. 166 to 169, 1999) written by T. Yamamoto et al. As one of the solutions, the paper has proposed a codoping method for simultaneously doping nitrogen to be an acceptor and a III group element to be a donor. More specifically, there have been described the effect of mutually bonding a III group element and nitrogen through codoping to enter a ZnO crystal, thereby preventing the instability of crystals from being caused by nitrogen doping and the effect of shallowing the acceptor level.

As described above, it has been proposed that a III group element such as Ga of an n-type dopant is simultaneously doped in addition to nitrogen of a p-type dopant in order to form the p-type ZnO based oxide semiconductor layer. However, when the simultaneous doping is to be actually carried out, there is the following problem. More specifically, since the III group element is activated as a donor very easily, it does not contribute to the promotion of a p-type depending on the conditions but acts as an n-type dopant. The condition is within a very small range of manufacturing conditions in order to carry out the promotion of a p-type through codoping. Therefore, to obtain the stable p-type ZnO based oxide layer the codoping is not suitable for mass production.

Moreover, also in the case of an element other than N to be the p-type dopant, there is a problem in that a reactivity of a dopant element and O is high and the element enters into O site required for an acceptor with difficulty in the presence of O to be the raw material of the ZnO based oxide.

### SUMMARY OF THE INVENTION

In consideration of the circumstances, it is an object of the present invention to provide a semiconductor device having a ZnO based oxide semiconductor layer such as a semiconductor light emitting device including a p-type ZnO based oxide semiconductor layer having a stable and high carrier concentration.

It is another object of the present invention to provide a method of manufacturing a semiconductor device including a p-type ZnO based oxide semiconducter layer in which phosphorus (P) is efficiently doped as a p-type dopant into an oxygen site of ZnO based oxide by bonding with Zn.

The present inventors vigorously made investigations in order to obtain the p-type ZnO based oxide semiconductor layer having a stable and high carrier concentration by doping a dopant other than N even if codoping is not carried out. As a result, it was found that the phosphorus (P) can be doped as the p-type dopant in a very stable state by the site selectivity in which the doping is carried out into the ZnO based oxide layer in a -Zn-P- state having a bond of zinc and phosphorus by using the compound of zinc and phosphorus as a doping material. Conventionally, the phosphorus (P) to be a V group element has generally been used as phosphine (PH₃). In this case, H is a reducing gas and is supposed to be unsuitable for etching an oxide. It has not been supposed that the P is used as the p-type dopant.

A semiconductor device according to the present invention comprises, a substrate, and at least a p-type ZnO based oxide semiconductor layer provided on the substrate, wherein the p-type ZnO based oxide semiconductor layer contains a phosphorus (P) as a dopant.

The ZnO based oxide semiconductor means an oxide containing Zn and includes an oxide of IIA group and Zn, IIB group and Zn or IIA group and IIB group and Zn in addition to ZnO as a specific example.

By such a structure, the phosphorus is used as a p-type dopant. For example, therefore, the doping can be carried out in the state of a compound with zinc, and P can reliably enter into an O site through a bond with Zn and can be doped to have a carrier concentration of approximately 1 × 10¹⁹ cm⁻³. As a result, the doping can be carried out in a stable carrier concentration. Thus, it is possible to obtain a semiconductor device including a p-type ZnO based oxide semiconductor layer having a high and constant carrier concentration.

The p-type layer may be contain the phosphorus (P) and a III group element or the phosphorus (P) and a V group element other than P as a dopant, for example. In this case, since the phosphorus is a subject of the dopant, the amount of the III group element is not excessively increased and the carrier concentration can further be increased while suppressing the instability of the codoping. Moreover, it is possible to obtain a carrier concentration of a latter half of 10¹⁹ cm⁻³ by the acceptor - acceptor codoping effect.

A semiconductor light emitting device according to the present invention comprises, a substrate, and a light emitting layer forming portion composed of ZnO based oxide semiconductor, in which at least an n-type layer and a p-type layer are provided so as to form a light emitting layer on the substrate, wherein the p-type layer contains a phosphorus as a dopant.

Moreover, a method of manufacturing a semiconductor device having a ZnO based oxide semiconductor layer according to the present invention is characterized in that when at least a p-type ZnO based oxide semiconductor layer is to be grown on a substrate, the p-type ZnO based oxide semiconductor layer is grown while supplying a compound of zinc and phosphorus together with raw materials constituting a ZnO based oxide. By using this method, the doping is carried out in the bonding state of Zn and P. Therefore, the bond of Zn-P is maintained to carry out the doping so that the P easily enters into the O site. As a result, the P acts as the p-type dopant so that a stable p-type ZnO based oxide semiconductor layer can be obtained.

### BRIEF DESCRIPTION OF THE DRAWINGS

Fig. 1 is a view illustrating the structure of an LED according to an embodiment of a semiconductor device in accordance with the present invention, and
Fig. 2 is a chart showing, together with a secondary ion strength of ZnO, a concentration of P obtained when a ZnO layer is grown by using Zn₃P₂ as a dopant material according to the present invention.

### DETAILED DESCRIPTION

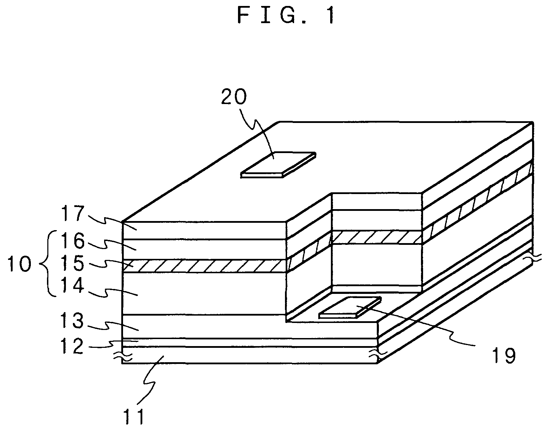

Next, a semiconductor device having a ZnO based oxide semiconductor layer and a method of manufacturing the same, and a method of growing a p-type ZnO based oxide semiconductor layer according to the present invention will be described with reference to the drawings. In the semiconductor device according to the present invention, a light emitting layer forming portion 10 composed of ZnO based oxide semiconductor comprises at least an n-type layer 14 and a p-type layer 16 to form a light emitting layer (portion), and is provided on a substrate 11 as shown in Fig. 1 illustrating an LED according to an embodiment. The p-type layer 16 contains phosphorus as a dopant.

In the example shown in Fig. 1, the light emitting layer forming portion 10 has such a structure that an active layer 15 composed of CdₓZn₁₋ₓO (0 ≤ x < 1, for example, x = 0.08) and having a thickness of approximately 0.1 µm is sandwiched between the n-type cladding layer 14 composed of Mg_{y}Zn_{1-y}O (0 ≤ y < 1, for example, y = 0.15) and having a thickness of approximately 2 µm and the p-type cladding layer 16 composed of Mg_{y}Zn_{1-y}O (0 ≤ y < 1, for example, y = 0.15) and having a thickness of approximately 2 µm. A p-type contact layer 17 composed of p-type ZnO is provided in a thickness of approximately 1 µm on the surface of the p-type cladding layer 16.

The present invention is characterized in that P is contained as a p-type dopant in the p-type cladding layer 16 and the p-type contact layer 17. More specifically, as described above, the present inventors vigorously made investigations to obtain a p-type ZnO based oxide semiconductor layer without using a codoping method. As a result, it was found the following. Specifically, in the case in which an AlGaAs layer is grown by a MOCVD (Metal Organic Chemical Vapor Deposition) method, for example, and trimethyl aluminum, trimethyl gallium or the like is used as a reaction gas of Al or Ga, C of the material (reaction gas) is bonded to Al or Ga and is combined with As or the like and C can enter into the site of a V group element to be a p-type dopant. By applying such a phenomenon, a material having a Zn-P bond is supplied during growth of ZnO based oxide. Consequently, P can be caused to enter into the O site of ZnO and can be doped to have a carrier concentration of approximately 1 x 10¹⁹ cm⁻³.

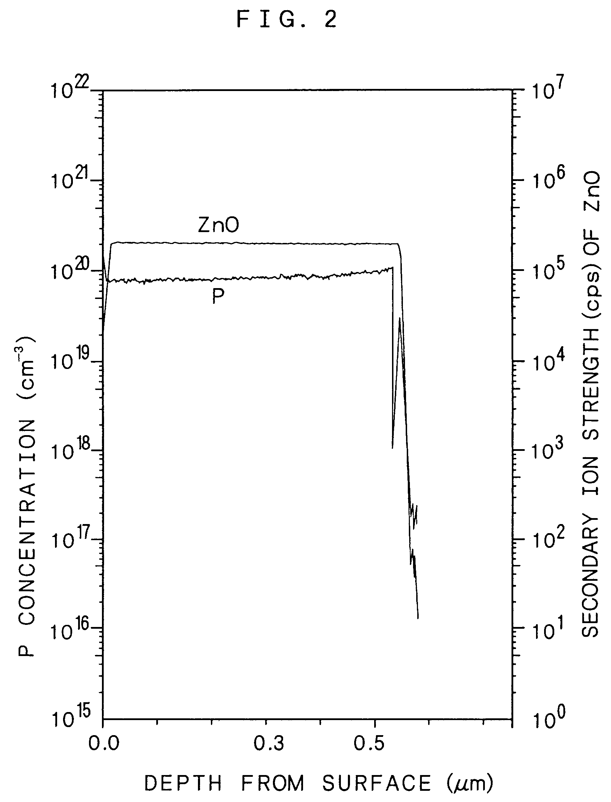

More specifically, in the case in which Zn₃P₂ or the like is used as a material for a p-type dopant at the step of growing a ZnO based oxide, in an MBE (Molecular Beam Epitaxy) method, for example, the P is doped into MgZnO or ZnO in a state of the Zn-P bond. For example, Fig. 2 shows, in contrast with the secondary ion strength (cps) of ZnO, a result of a P concentration (atoms / cm³) in the ZnO layer obtained through a SIMS (secondary ion mass spectrometer) analysis. The ZnO layer is grown in a thickness of approximately 0.5 µm on a sapphire substrate by simultaneously supplying Zn₃P₂, plasma oxygen, Zn and plasma excitation nitrogen (N₂) by the MBE method at a temperature of approximately 600 °C. The cell temperature of Zn₃P₂ is controlled to be approximately 150 to 300 °C. It is apparent from Fig. 2 that P having a concentration of 8 × 10¹⁹ cm⁻³ or more is taken into crystals and a p-type ZnO layer having a high carrier concentration is obtained. The nitrogen acts as a codopant and has a concentration of approximately 5 × 10¹⁸ cm⁻³.

The reason why the doping of P is thus carried out at a very high concentration is supposed such as following. Since a compound of Zn and P is used as the dopant material as described above, and a combination of P with more active oxygen, zinc or the like is originally carried out in the bonding state of Zn-P. For this reason, even if P to be a part of the Zn-P bond is liberated and oxygen comes into that place, the bonding of Zn and P can easily be maintained differently from the case in which P or the like pushes away the oxygen and comes thereinto. Consequently, the bond of Zn-P is largely present and P enters the ZnO based oxide in a stable state.

By simultaneously supplying N as described above, the acceptor - acceptor codoping is carried out so that the P-N bond is generated and the acceptor level of P is shallowed. Consequently, the carrier concentration can be increased. However, if the amount of other V group elements is too increased, instability is remarkably caused by the codoping. Therefore, a compound of Zn and P should be a subject and the N concentration should be controlled to be approximately 20 to 80% of P. Thus, N is doped in a concentration of approximately 50% of P while setting the compound of Zn and P to be a subject. Consequently, a p-type ZnO layer having a carrier concentration of approximately 5 × 10¹⁹ cm⁻³ is obtained.

Next, a method for manufacturing an LED shown in Fig. 1 will be described. For example, the sapphire substrate 11 is set into an MBE device, for example, and a substrate temperature is set to 600 to 700 °C and thermal cleaning is carried out. Then, the substrate temperature is set to approximately 400 °C and the shutters of an oxygen radical (O*) source (cell) and a Zn source (cell) are opened for irradiation. Consequently, a buffer layer 12 composed of ZnO is formed in a thickness of approximately 50 nm to 0.1 µm.

Subsequently, the irradiation of the oxygen is stopped to set the substrate temperature to approximately 550 to 600 °C and the shutter of the oxygen radical is then opened again to irradiate the oxygen radical and Zn and the shutter of Al or Ga to be an n-type dopant is also opened so that an n-type contact layer 13 composed of n-type ZnO is grown in a thickness of approximately 1.5 µm. Then, the shutter of Mg is also opened to grow an n-type cladding layer 14 composed of Mg_{y}Zn_{1-y}O (0 ≤ y < 1, for example, y = 0.15) in a thickness of approximately 2 µm, and the supply of Mg is stopped and the shutter of Cd is opened to grow an undoped active layer 15 composed of CdₓZn₁₋ₓO (0 ≤ x < 1, for example, x = 0.08) in a thickness of approximately 0.1 µm.

Thereafter, the supply of Cd is stopped to open the shutter of Mg is opened again, and furthermore, the shutters of Zn₃P₂ and plasma excitation nitrogen are opened to grow a p-type cladding layer 16 composed of p-type Mg_{y}Zn_{1-y}O doped with P and N (0 ≤ y < 1, for example, y = 0.15) in a thickness of approximately 2 µm. Furthermore, the supply of Mg is stopped to sequentially grow a p-type contact layer 17 composed of p-type ZnO in a thickness of approximately 1 µm. In this case, the cell temperature of Zn₃P₂ is controlled to be approximately 150 to 300 °C. If the cell temperature of Zn₃P₂ is too high, a ZnO based oxide crystal is broken, and if it is too low, a series resistance is increased due to residual n-type carrier compensation. A light emitting layer forming portion 10 is constituted by the n-type cladding layer 14, the active layer 15 and the p-type cladding layer 16.

Subsequently, the supply of all the materials is stopped to slowly drop the substrate temperature at a rate of 5 to 10 °C every minute. After the substrate temperature is fully dropped, a wafer subjected to epitaxial growth is taken out of the MBE apparatus. According to the present invention, the carrier concentrations of the p-type layers 16 and 17 can be increased. Therefore, a transparent conductive film for current diffusion may be provided but does not always need to be provided. Then, a part of the provided semiconductor layer is subjected to dry etching such as a RIE method, thereby exposing an n-type contact layer 13 and polishing the sapphire substrate 11 to set the thickness of the substrate 11 to be approximately 100 µm. A p-side electrode 20 formed of Ni/Al and an n-side electrode 19 formed of Ti/Au are provided on the p-type contact layer 17 and the surface of the n-type contact layer 13 exposed by the etching through vacuum evaporation using a lift-off method, for example, respectively. Subsequently, a chip is cut away from the wafer so that an LED chip shown in Fig. 1 is obtained.

While the light emitting layer forming portion 10 is an LED chip having a double hetero junction in this example, another junction structure such as a pn junction structure of a hetero junction or a homo junction may be used. Moreover, LD may be obtained in place of the LED. In this case, for example, it is preferable that the active layer 15 should be formed with a multi-quantum well structure in which two to five respectively barrier layers and well layers formed of non-doped Cd_{0.03}Zn_{0.97}O / Cd_{0.2}Zn_{0.8}O are alternately provided in thicknesses of 5 nm and 4 nm, respectively.

Moreover, in the case in which the active layer 15 is thin and light cannot be fully confined in the active layer 15, light guide layers formed of ZnO are provided on both sides of the active layer, for example. Furthermore, the p-side electrode 20 is directly formed by stripe-like patterning, the upper portion of the semiconductor layers is etched into a mesa shape or a current constricting layer is buried. Consequently, a structure for defining a current injection region is formed.

According to the present invention, it is possible to obtain a light emitting device using a ZnO based oxide semiconductor having a high p-type carrier concentration. Therefore, it is possible to obtain an LED having a very low operating voltage and a high light emission efficiency or an LD having a low operating voltage and a small threshold current.

While the ZnO based compound semiconductor layer is grown on the sapphire substrate by the MBE method in the above-mentioned example, a p-type layer having a high carrier concentration can also be formed by using an organic metal gas comprising the compound of Zn and P described above in the MOCVD method.

Furthermore, while the example of the ZnO based oxide semiconductor light emitting device of the LED or the LD has been described in the above example, the p-type layer of the light emitting device can be formed in a high carrier concentration. Therefore, a driving voltage can be greatly reduced so that a semiconductor light emitting device having a high characteristic can be obtained. It is also possible to implement, with high performance, a ZnO based semiconductor device such as a transparent electrode (conductive film), a transparent TFT, a SAW device, a pyroelectric device or a piezoelectric device in addition to a light emitting device.

According to the present invention, the ZnO based oxide semiconductor is doped with phosphorus which cannot conventionally be doped. Therefore, the doping can be carried out very stably in spite of the doping state in a high concentration. Thus, a p-type ZnO based oxide semiconductor layer having a high carrier concentration can be obtained. As a result, it is possible to manufacture an LED, a laser diode or the like by using the ZnO based oxide semiconductor layer and to obtain a semiconductor light emitting device having a very excellent light emitting characteristic from a blue region to an ultraviolet region.

Moreover, the p-type ZnO based oxide semiconductor layer having a high carrier concentration can be obtained and can be thereby used for a SAW device, a transparent TFT, a transparent conductive film, a piezoelectric device, a pyroelectric device, a gas sensor or the like in addition to a light emitting device.

Although preferred examples have been described in some detail it is to be understood that certain changes can be made by those skilled in the art without departing from the spirit and scope of the invention as defined by the appended claims.

In an LED, for example, a light emitting layer forming portion (10) composed of a ZnO based oxide semiconductor is provided on a substrate (11), which includes at least an n-type layer (14) and a p-type layer (16) to form a light emitting layer. The p-type layer (16) contains phosphorus as a dopant. In order to dope such phosphorus, for example, a material having a bond of Zn and P such as Zn₃P₂ is used when growing a ZnO based oxide semiconductor. As a result, it is possible to obtain a semiconductor device including a p-type ZnO based oxide semiconductor layer having a stable and high carrier concentration and a method of manufacturing the semiconductor device.

## Claims

1. A semiconductor device comprising:
a substrate, and
at least a p-type ZnO based oxide semiconductor layer provided on said substrate,
wherein said p-type ZnO based oxide semiconductor layer contains a phosphorus (P) as a dopant.

2. The semiconductor device of claim 1, wherein said p-type layer contains, as a dopant, said phosphorus (P) and a III group element or said phosphorus (P) and a V group element other than said phosphorus (P).

3. A semiconductor light emitting device comprising:
a substrate, and
a light emitting layer forming portion composed of ZnO based oxide semiconductor, in which at least an n-type layer and a p-type layer are provided so as to form a light emitting layer on said substrate,
wherein said p-type layer contains a phosphorus as a dopant.

4. The semiconductor light emitting device of claim 3, wherein said p-type layer contains a V group element other than said phosphorus.

5. The semiconductor light emitting device of claim 3, wherein said light emitting layer forming portion constitutes a light emitting diode or a laser diode.

6. The semiconductor light emitting device of claim 5, wherein said light emitting layer forming portion is formed by a double hetero structure in which an active layer composed of CdₓZn₁₋ₓO (0 ≤ x < 1) is interposed by cladding layers composed of Mg_{y}Zn_{1-y}O (0 ≤ y < 1).

7. A method of manufacturing a semiconductor device for growing at least a p-type ZnO based oxide semiconductor layer on a substrate,
wherein said p-type ZnO based oxide semiconductor layer is grown while supplying a compound of zinc and phosphorus together with raw materials constituting a ZnO based oxide.

8. The method of claim 7, wherein said compound of zinc and phosphorus is Zn₃P₂.
